(19) Europäisches Patentamt
European Patent Office
Office européen des brevets

(11) **EP 4 530 321 A1**

(12) **EUROPEAN PATENT APPLICATION**
published in accordance with Art. 153(4) EPC

(43) Date of publication:
**02.04.2025 Bulletin 2025/14**

(21) Application number: **23834515.1**

(22) Date of filing: **16.05.2023**

(51) International Patent Classification (IPC):
***C09D 11/101*** *(2014.01)* ***C09D 11/30*** *(2014.01)*
***C09D 11/36*** *(2014.01)* ***C09D 183/04*** *(2006.01)*
***H01L 33/56*** *(2010.01)* ***C08L 83/04*** *(2006.01)*
***H01B 3/46*** *(2006.01)*

(52) Cooperative Patent Classification (CPC):
Y02E 10/549

(86) International application number:
**PCT/CN2023/094582**

(87) International publication number:
**WO 2024/007741 (11.01.2024 Gazette 2024/02)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **06.07.2022 CN 202210790328**

(71) Applicant: **Hangzhou First Applied Material Co., Ltd.**
**Hangzhou, Zhejiang 311300 (CN)**

(72) Inventors:
- **HONG, Haibing**
  **Hangzhou, Zhejiang 311300 (CN)**
- **YANG, Chufeng**
  **Hangzhou, Zhejiang 311300 (CN)**
- **SHEN, Xin**
  **Hangzhou, Zhejiang 311300 (CN)**
- **WANG, Shihao**
  **Hangzhou, Zhejiang 311300 (CN)**
- **DENG, Wei**
  **Hangzhou, Zhejiang 311300 (CN)**

(74) Representative: **Dehns Germany Partnerschaft mbB**
**Theresienstraße 6-8**
**80333 München (DE)**

# (54) INK COMPOSITION, PACKAGING STRUCTURE, AND SEMICONDUCTOR DEVICE

(57) Provided are an ink composition, a package structure, and a semiconductor device. The ink composition includes: a photocurable silicon-containing monomer component, an active diluent component, and a photoinitiator component, wherein the photocurable silicon-containing monomer component comprises any one or more compounds having the following structural formula (I). By applying the technical solution of the present application, a fluorine-substituted silicon-containing monomer is combined with the active diluent component to form a free radical curing system, which can effectively reduce the dielectric constant and improve the curing speed. Due to the high boiling point of the fluorine-substituted silicon-containing monomer in the ink composition of the present application, it is not easy to evaporate, avoiding blockage of ink holes during use and better meeting the requirements of ink-jet printing in the prior art. In addition, the fluorine-substituted silicon-containing monomer of the present application is simple to prepare, and the raw materials are cheap and easy to obtain, with low production costs, making it easy to promote and apply.

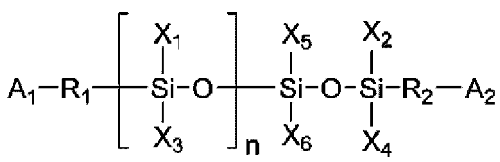

structural formula (I)

EP 4 530 321 A1

## Description

### Technical Field

The present disclosure relates to the field of organic package material technology, specifically to an ink composition, a package structure, and a semiconductor device.

### Background

Organic light-emitting diodes (OLEDs) have become the mainstream of the new generation of display technology and the future direction of display development due to their excellent characteristics such as active luminescence, low driving voltage, high luminescence brightness, high luminescence efficiency, wide luminescence viewing angle, fast response speed, ultra-thin and ultra-light, low cost, low power consumption, wide operating temperature range, simple structure, and applicability to flexible panels. Their potential applications in various intelligent terminal fields are enormous.

At present, the industrial development and application of OLED devices are constrained by problems such as insufficient stability and reliability, and short service life. This is mainly because the materials and structures in OLED devices are sensitive to water vapor and oxygen. Once they come into contact with water and oxygen, the luminescence efficiency, working performance, stability, and service life of the devices will rapidly decrease. Thin film package is achieved by stacking and depositing dense thin films on a substrate of OLED devices, which can effectively block the invasion of water vapor and oxygen, ensuring the reliability and service life of OLED devices.

The increasing complexity of OLED device package imposes increasingly stringent requirements on the materials used. Specifically, the requirements for polymer materials used in package are becoming increasingly stringent. For example, organic polymer film materials used as adhesives, protective layers, and interlayers in optical devices are developing towards the demand for light weight, thin thickness, and miniaturization. Meanwhile, as the finished product structure becomes more complex, the physical requirements for these layers correspondingly increase. The existing interlayers with a thin film package thickness of 1 micron not only require planarization function but also cannot contain gaps and holes to provide appropriate spacing function. Due to thinning between layers, the thickness and forming process between each layer are more precise, which requires a precise and consistent ink-jet printing method to deposit organic layers. In addition, another function performed by thin interlayers in multilayer optical and electronic devices is electrical insulation, in order to electrically isolate one or a series of layers from other nearby layers.

The arrival of the 5G communication era and the updating and iteration of various electronic terminal applications have put forward more stringent and comprehensive requirements for the functional characteristics and package effects of semiconductor display device package materials. Organic thin film package materials with excellent dielectric properties such as low dielectric constant and low dielectric loss are gradually becoming a development trend.

The patent application number CN201880082492.X of 3M Company described a use of a branched alkyl (meth) acrylate monomer containing 12 or more carbon atoms to form an amorphous optical clear layer with a dielectric constant of less than or equal to 3.0 at 1 megahertz during curing. However, the hardness exhibited by an acrylate compound with a full alkyl chain when cured into a film was often insufficient.

SDI Company described in patent application number TW 202130677 A that a lower dielectric constant material was obtained by compounding an INK composition using a (meth)acrylic monomer modified with a cyclopentadiene dimer and a (meth)acrylic functional monomer of a phenylsilane, along with other excipients. However, the phenylsilane often had a high viscosity and was difficult to achieve colorless and transparent color.

LG Company described in patent application number US20220002569 that a lower dielectric constant material was obtained by compounding an INK composition using (meth)acrylic monomers with bicyclic and tricyclic structures along with other excipients. However, the patent did not report any other data except for the dielectric constant data.

The patent application number CN20200109954.X described a use of a (meth)acrylate monomer derivative to be added with a low dielectric PIB adhesive oligomer, resulting in a polymer layer with a dielectric constant of less than or equal to 3.0 at 1 megahertz. Due to the high viscosity of the polymer, it is not possible to form an organic layer using ink-jet printing technology.

In addition, the Chinese patent application with the publication number CN 113004808 A also disclosed an ink composition that could obtain a low dielectric material, using a low boiling point fluorine-containing monomer as a main functional monomer of the ink. However, due to its low boiling point, it is easy to block ink holes during high-temperature ink-jet printing.

### Summary

The main objective of the present disclosure is to provide an ink composition, a package structure, and a semiconductor device to solve the problems of high dielectric constant of a package material and easy blockage of a spray

head during the printing process in the prior art.

In order to achieve the above-mentioned objective, according to one aspect of the present disclosure, provided is an ink composition, which comprises: a photocurable silicon-containing monomer component, an active diluent component, and a photoinitiator component, wherein the photocurable silicon-containing monomer component includes any one or more compounds having the following structural formula I:

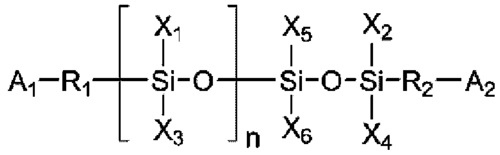

structural formula I

where n is any integer from 0 to 50; $R_1$ and $R_2$ are the same or different, and are each independently selected from any one of a single bond, a substituted or unsubstituted $C_1$ to $C_{50}$ alkylene group, a substituted or unsubstituted $C_3$ to $C_{50}$ cycloalkylene group, a substituted or unsubstituted $C_1$ to $C_{50}$ alkylene ether group, a substituted or unsubstituted $C_6$ to $C_{50}$ arylene group, or a substituted or unsubstituted $C_7$ to $C_{50}$ arylalkylene group; $X_1$, $X_2$, $X_3$, $X_4$, $X_5$, and $X_6$ are the same or different, and are each independently selected from any one of a hydrogen, a substituted or unsubstituted $C_1$ to $C_{50}$ alkyl group, a substituted or unsubstituted $C_1$ to $C_{50}$ alkyl ether group, a substituted or unsubstituted $C_1$ to $C_{50}$ cycloalkyl group, a substituted or unsubstituted $C_1$ to $C_{50}$ alkyl sulfide group, a substituted or unsubstituted $C_6$ to $C_{50}$ aryl group, a substituted or unsubstituted $C_3$ to $C_{50}$ heteroaryl group, a substituted or unsubstituted $C_7$ to $C_{50}$ aralkyl group, or $-NR_6R_7$, wherein $R_6$ and $R_7$ each independently is a $C_1$ to $C_{50}$ alkyl group; $A_1$ and $A_2$ are the same or different, and are independently selected from any one of a hydrogen, a substituted or unsubstituted $C_1$ to $C_{50}$ alkyl group, a substituted or unsubstituted $C_1$ to $C_{60}$ alkyl ether group, a substituted or unsubstituted $C_1$ to $C_{50}$ alkyl sulfide group, a substituted or unsubstituted $C_6$ to $C_{50}$ aryl group, a substituted or unsubstituted $C_7$ to $C_{50}$ aralkyl group, $-NR_8R_9$, a substituted or unsubstituted acrylic ester group, a substituted or unsubstituted $C_3$ to $C_{60}$ epoxyalkyl group, a substituted or unsubstituted $C_2$ to $C_{60}$ epoxy group, or a substituted or unsubstituted $C_2$ to $C_{60}$ alkenyl ether group, wherein $R_8$ and $R_9$ each independently is a $C_1$ to $C_{50}$ alkyl group; and in the photocurable silicon-containing monomer component, at least one of $A_1$ and $A_2$ is represented by any one of structural formula II:

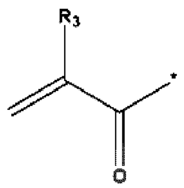

structural formula II

wherein * represents a binding position, and $R_3$ is independently selected from one of -F or $-CF_3$.

Furthermore, n is any integer from 1 to 10, and preferably, $R_1$ and $R_2$ are each independently selected from any one of a substituted or unsubstituted $C_1$ to $C_{10}$ alkylene group, or a substituted or unsubstituted $C_1$ to $C_{10}$ alkylene ether group;

preferably, $X_1$, $X_2$, $X_3$, $X_4$, $X_5$, and $X_6$ are each independently selected from any one of a hydrogen, a substituted or unsubstituted $C_1$ to $C_{10}$ alkyl group, a substituted or unsubstituted $C_6$ to $C_{10}$ aryl group, or a substituted or unsubstituted $C_7$ to $C_{11}$ aralkyl group; and

more preferably, the photocurable silicon-containing monomer component is a combination of multiple compounds having structural formula I.

Furthermore, the photocurable silicon-containing monomer component is selected from the following compound structures:

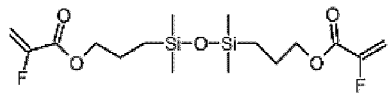
1-1 ,

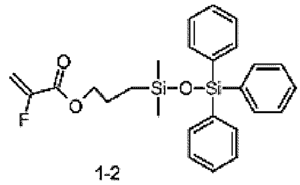
1-2 ,

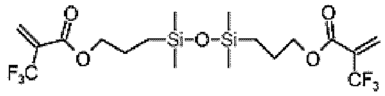
1-3 ,

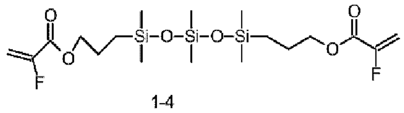
1-4 ,

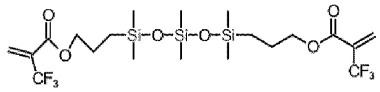
1-5 ,

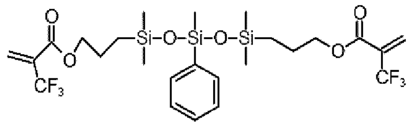
1-6 ,

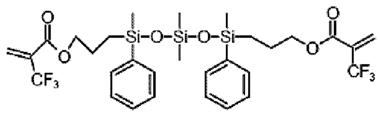
1-7 ,

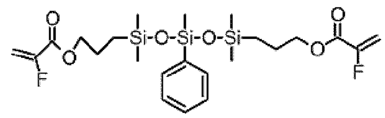
1-8 ,

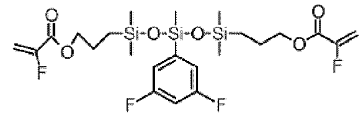
1-9 ,

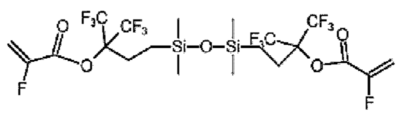
1-10 ,

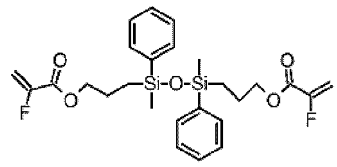
1-11 , or

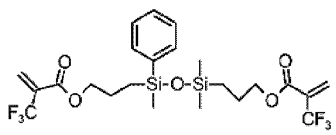
1-12 .

Furthermore, the active diluent component includes any one or more of the structures shown in structural formula V,

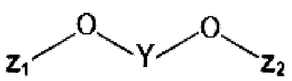
structural formula V

wherein Y is selected from any one of a single bond, a substituted or unsubstituted $C_1$ to $C_{50}$ alkylene group, a substituted or unsubstituted $C_3$ to $C_{50}$ cycloalkylene group, a substituted or unsubstituted $C_1$ to $C_{50}$ alkylene ether group, a substituted or unsubstituted $C_6$ to $C_{50}$ arylene group, a substituted or unsubstituted $C_7$ to $C_{50}$ arylalkylene group, or $-N(R_{11})-R_{12}-$; wherein $R_{11}$ is any one of a hydrogen, or a substituted or unsubstituted $C_1$ to $C_{50}$ alkyl group, and $R_{12}$ is any one of a substituted or unsubstituted $C_1$ to $C_{50}$ alkylene group; $Z_1$ and $Z_2$ are each independently selected from any one of a hydrogen, a substituted or unsubstituted $C_1$ to $C_{50}$ alkyl group, a substituted or unsubstituted $C_1$ to $C_{60}$ alkyl ether group, a substituted or unsubstituted acrylic ester group, or a substituted or unsubstituted $C_2$ to $C_{60}$ alkenyl ether group, and at least one of $Z_1$ and $Z_2$ is represented by any one of structural formula VI,

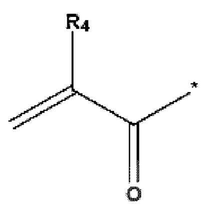
structural formula VI

wherein $R_4$ is selected from any one of a hydrogen, or a substituted or unsubstituted $C_1$ to $C_{50}$ alkyl group; and preferably, Y is selected from any one of a substituted or unsubstituted $C_1$ to $C_{10}$ alkylene group, a substituted or unsubstituted $C_1$ to $C_{10}$ alkylene ether group, a substituted or unsubstituted $C_6$ to $C_{10}$ arylene group, or a substituted or unsubstituted $C_7$ to $C_{11}$ arylalkylene group.

Furthermore, the active diluent component includes any one or more selected from the group consisting of a monofunctional active diluent, a bifunctional active diluent, and a multifunctional active diluent;

optionally, the monofunctional active diluent includes any one or more selected from the group consisting of lauryl acrylate, ethoxyethoxyethyl acrylate, butyl acrylate, hydroxyethyl acrylate and isobornyl acrylate, tetralydrofufuryl ethoxyacrylate, phosphate methacrylate, 2-methyl-2-adamantyl acrylate, and isobornyl methacrylate;
optionally, the bifunctional active diluent includes any one or more selected from the group consisting of ethylene diacrylate, propylene glycol diacrylate, and other glycol diacrylate; and
optionally, the multifunctional active diluent includes one or more selected from the group consisting of trimethylolpropane triacrylate, pentaerythritol triacrylate, trimethylolpropane trimethacrylate, trimethylolpropane propoxylate triacrylate, pentaerythritol propoxylate tetraacrylate, ditrimethylolpropane tetraacrylate, triethylene glycol dimethacrylate, long-chain aliphatic hydrocarbon glycidyl ether acrylate, dipentaerythritol hexaacrylate, tripropylene glycol diacrylate, phthalic diglycol diacrylate, ethoxylated trimethylolpropane triacrylate, propoxylate trimethylolpropane triacrylate, propylene glycerol triacrylate, 3-(2-hydroxyethyl)isocyanurate triacrylate, and ethoxylated neopentyl glycol methoxy monoacrylate.

Furthermore, the photoinitiator component includes any one or more selected from the group consisting of a benzoin initiator and a derivative initiator thereof, a benzil initiator and a derivative initiator thereof, an acetophenone derivative initiator, an alpha-hydroxyketone derivative initiator, an alpha-aminoketone derivative initiator, a methyl benzoylformate initiator, an acyl phosphorus oxide initiator, a benzophenone initiator, a thioanthrone initiator, and an anthraquinone initiator and a derivative initiator thereof.

Furthermore, by weight percentage, the ink composition includes: 0.01%-50% of the photocurable silicon-containing monomer component, 30%-80% of the active diluent component, and 0.01%-20% of the photoinitiator component; preferably, by weight percentage, the content of the photocurable silicon-containing monomer component is 15%-50%, the content of the active diluent component is 40%-80%, and the content of the photoinitiator component is 1%-10%.

Furthermore, the ink composition further includes an adjuvant component. Preferably, the adjuvant component is selected from any one or more of a polymerization inhibitor, a surfactant, an antioxidant, a defoamer, or a leveling agent. More preferably, the content of the adjuvant component is 0.01 wt%-5 wt%.

Furthermore, a viscosity of the ink composition at 25°C is 1 mPa·s-50 mPa·s.

According to another aspect of the present disclosure, provided is a package structure including an organic layer, wherein the organic layer is formed by photocuring any one of the ink compositions described above.

According to still another aspect of the present disclosure, provided is a semiconductor device including a functional structure and a package structure, wherein the package structure is the package structure described above.

Furthermore, the semiconductor device is any one of an electroluminescent device, a photoluminescent device, a lighting apparatus, a light-emitting diode, a solar cell, a thin film transistor, and a photodetector.

By applying the technical solution of the present disclosure, a photocurable silicon-containing monomer component with the above-mentioned structural formula I is used as a polymerized monomer. In the photocurable silicon-containing monomer component, at least one of $A_1$ and $A_2$ is represented by any one of structural formula II, that is, the photocurable monomer component is a fluorine-substituted photocurable silicon-containing monomer. In the present application, a fluorine-substituted silicon-containing monomer is combined with the active diluent component to form a free radical curing system, which can effectively reduce the dielectric constant and improve the curing speed. Due to the high boiling point of the fluorine-substituted silicon-containing monomer in the ink composition of the present application, it is not easy to evaporate, avoiding blockage of ink holes during use and better meeting the requirements of ink-jet printing in the prior art. In addition, the fluorine-substituted silicon-containing monomer of the present application is simple to prepare, and the raw materials are cheap and easy to obtain, with low production costs, making it easy to promote and apply.

## Detailed Description of the Embodiments

It should be noted that the embodiments and the features of the embodiments in the present application can be combined with each other under the circumstances that there is no conflict. The present disclosure will be described in detail below with reference to embodiments.

In the present application, the term "substituted or unsubstituted" refers to substitution by one or more substituents selected from the following: deuterium; a halogen group; a nitrile group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; or a hetero-cyclic

group containing at least one of N, O, or S, or no substituent, or substituting with a substituent connected by two or more substituents of the illustrated substituents, or no substituent. For example, the term "substituent connected by two or more substituents" can refer to a biphenyl group. The biphenyl group can be an aryl group or can be interpreted as a substituent where two phenyl groups are connected.

As analyzed in the background technology of the present application, the dielectric constant of a commonly used package material in the prior art is too high to meet the requirements of the updating and iterating of a semiconductor device. Although some low dielectric constant ink compositions have been disclosed, they still have various defects and are difficult to promote and use. In response to this situation, the present application provides an ink composition, a package structure, and a semiconductor device.

According to a typical embodiment of the present application, provided is an ink composition, which includes: a photocurable silicon-containing monomer component, an active diluent component, and a photoinitiator component, wherein the photocurable silicon-containing monomer component includes any one or more compounds having the following structural formula I:

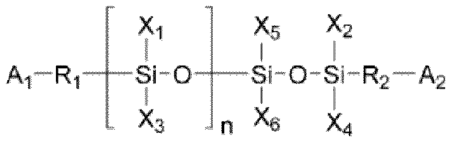

structural formula I

where n is any integer from 0 to 50; $R_1$ and $R_2$ are the same or different, and are each independently selected from any one of a single bond, a substituted or unsubstituted $C_1$ to $C_{50}$ alkylene group, a substituted or unsubstituted $C_3$ to $C_{50}$ cycloalkylene group, a substituted or unsubstituted $C_1$ to $C_{50}$ alkylene ether group, a substituted or unsubstituted $C_6$ to $C_{50}$ arylene group, or a substituted or unsubstituted $C_7$ to $C_{50}$ arylalkylene group; $X_1$, $X_2$, $X_3$, $X_4$, $X_5$, and $X_6$ are the same or different, and are each independently selected from any one of a hydrogen, a substituted or unsubstituted $C_1$ to $C_{50}$ alkyl group, a substituted or unsubstituted $C_1$ to $C_{50}$ alkyl ether group, a substituted or unsubstituted $C_1$ to $C_{50}$ cycloalkyl group, a substituted or unsubstituted $C_1$ to $C_{50}$ alkyl sulfide group, a substituted or unsubstituted $C_6$ to $C_{50}$ aryl group, a substituted or unsubstituted $C_3$ to $C_{50}$ heteroaryl group, a substituted or unsubstituted $C_7$ to $C_{50}$ aralkyl group, or $-NR_6R_7$, wherein $R_6$ and $R_7$ each independently is a $C_1$ to $C_{50}$ alkyl group; $A_1$ and $A_2$ are the same or different, and are independently selected from any one of a hydrogen, a substituted or unsubstituted $C_1$ to $C_{50}$ alkyl group, a substituted or unsubstituted $C_1$ to $C_{60}$ alkyl ether group, a substituted or unsubstituted $C_1$ to $C_{50}$ alkyl sulfide group, a substituted or unsubstituted $C_6$ to $C_{50}$ aryl group, a substituted or unsubstituted $C_7$ to $C_{50}$ aralkyl group, $-NR_8R_9$, a substituted or unsubstituted acrylic ester group, a substituted or unsubstituted $C_3$ to $C_{60}$ epoxyalkyl group, a substituted or unsubstituted $C_2$ to $C_{60}$ epoxy group, or a substituted or unsubstituted $C_2$ to $C_{60}$ alkenyl ether group, wherein $R_8$ and $R_9$ each independently is a $C_1$ to $C_{50}$ alkyl group; and in the photocurable silicon-containing monomer component, at least one of $A_1$ and $A_2$ is represented by any one of structural formula II:

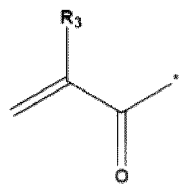

structural formula II

wherein * represents a binding position, and $R_3$ is independently selected from one of -F or $-CF_3$.

The present application uses a photocurable silicon-containing monomer component with the above-mentioned structural formula I as a polymerized monomer. In the photocurable silicon-containing monomer component, at least one of $A_1$ and $A_2$ is represented by any one of structural formula II, that is, the photocurable monomer component is a fluorine-substituted photocurable silicon-containing monomer. In the present application, a fluorine-substituted silicon-containing monomer is combined with an active diluent component to form a free radical curing system, which can effectively reduce the dielectric constant and improve the curing speed. Due to the high boiling point of the fluorine-substituted silicon-containing monomer in the ink composition of the present application, it is not easy to evaporate, avoiding blockage of ink holes during use and better meeting the requirements of ink-jet printing in the prior art. In addition, the fluorine-substituted silicon-containing monomer of the present application is simple to prepare, and the raw materials are cheap and easy to obtain, with low production costs, making it easy to promote and apply.

When n in structural formula I is any integer from 1 to 10, the resulting photocurable silicon-containing monomer component is relatively easy to prepare and more conducive to improving the photocuring rate and curing shrinkage rate of

the ink composition, with a lower dielectric constant and improved overall performance of the ink composition.

In some preferred embodiments of the present application, $R_1$ and $R_2$ in structural formula I are each independently selected from any one of a substituted or unsubstituted $C_1$ to $C_{10}$ alkylene group, or a substituted or unsubstituted $C_1$ to $C_{10}$ alkylene ether group, wherein the substituted or unsubstituted alkylene ether group is $-O-R_5-$, and $R_5$ is one of the substituted or unsubstituted $C_1$ to $C_{10}$ alkylene group, which can further improve the overall performance of the ink composition containing the photocurable monomer component.

In some preferred embodiments of the present application, $X_1$, $X_2$, $X_3$, $X_4$, $X_5$, and $X_6$ in structural formula I are each independently selected from any one of a hydrogen, a substituted or unsubstituted $C_1$ to $C_{10}$ alkyl group, a substituted or unsubstituted $C_6$ to $C_{10}$ aryl group, or a substituted or unsubstituted $C_7$ to $C_{11}$ aralkyl group, which are beneficial for improving the photocuring rate, curing shrinkage rate, light transmittance, and dielectric loss properties of the ink composition, and the compound sources are relatively abundant.

In some embodiments of the present application, $A_1$ and $A_2$ in the above-mentioned structural formula I can be the same or different, and at least one of them is selected from the group represented in structural formula III or structural formula IV, that is, one of $A_1$ and $A_2$ is selected from the group represented in structural formula III or structural formula IV, or both $A_1$ and $A_2$ are selected from any one or two of the groups represented in structural formula III or structural formula IV:

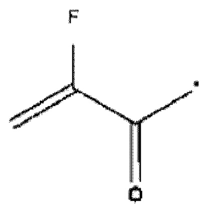

structural formula III

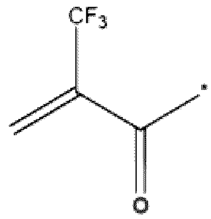

structural formula IV.

In some preferred embodiments of the present application, $A_1$ and $A_2$ in structural formula I are both selected from any one or both of the groups represented in structural formula III or structural formula IV. **The** corresponding ink composition exhibits particularly good dielectric constant and good overall performance.

The above-mentioned photocurable silicon-containing monomer component can be a compound with the structure shown in structural formula I, a combination of multiple compounds with the above-mentioned structure, or a combination of one or more compounds with the structure shown in structural formula I and a photocurable silicon-containing monomer component in the prior art.

In some embodiments of the present application, in order to further reduce the dielectric constant of the ink composition and improve its overall performance, the photocurable silicon-containing monomer is selected from the following compound structures:

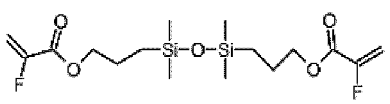

1-1 ,

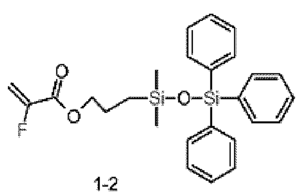

1-2 ,

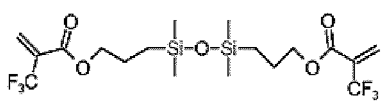

1-3 ,

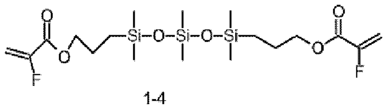
1-4 ,
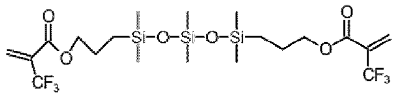
1-5 ,
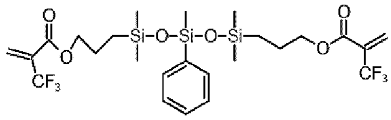
1-6 ,

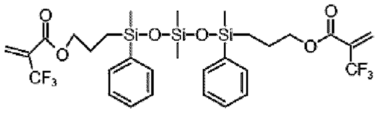
1-7 ,
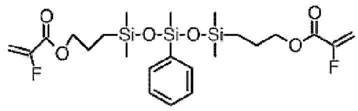
1-8 ,
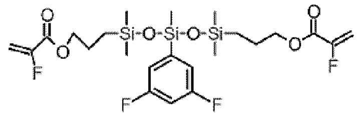
1-9 ,

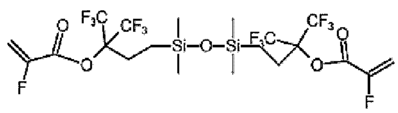
1-10 ,
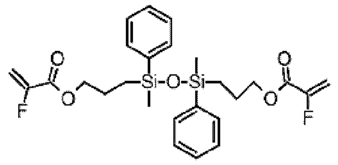
1-11 , or
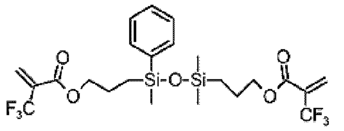
1-12 .

The above-mentioned active diluent component can be selected from a photocurable monomer in the prior art. In some embodiments of the present application, the active diluent component includes any one or more of the structures shown in structural formula V,

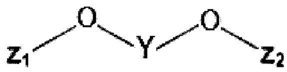
structural formula V

wherein Y is selected from any one of a single bond, a substituted or unsubstituted $C_1$ to $C_{50}$ alkylene group, a substituted or unsubstituted $C_3$ to $C_{50}$ cycloalkylene group, a substituted or unsubstituted $C_1$ to $C_{50}$ alkylene ether group, a substituted or unsubstituted $C_6$ to $C_{50}$ arylene group, a substituted or unsubstituted $C_7$ to $C_{50}$ arylalkylene group, or $-N(R_{11})-R_{12}-$; wherein $R_{11}$ is any one of a hydrogen, or a substituted or unsubstituted $C_1$ to $C_{50}$ alkyl group, and $R_{12}$ is any one of a substituted or unsubstituted $C_1$ to $C_{50}$ alkylene group; $Z_1$ and $Z_2$ are each independently selected from any one of a hydrogen, a substituted or unsubstituted $C_1$ to $C_{50}$ alkyl group, a substituted or unsubstituted $C_1$ to $C_{60}$ alkyl ether group, a substituted or unsubstituted acrylic ester group, or a substituted or unsubstituted $C_2$ to $C_{60}$ alkenyl ether group, and at least one of $Z_1$ and $Z_2$ is represented by any one of structural formula VI,

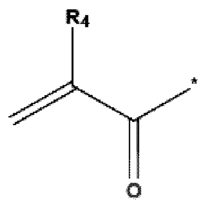
structural formula VI

wherein $R_4$ is selected from any one of a hydrogen, and a substituted or unsubstituted $C_1$ to $C_{50}$ alkyl group.

In some preferred embodiments, Y in structural formula V is selected from any one of a substituted or unsubstituted $C_1$ to $C_{10}$ alkylene group, a substituted or unsubstituted $C_1$ to $C_{10}$ alkylene ether group, a substituted or unsubstituted $C_6$ to $C_{10}$ arylene group, or a substituted or unsubstituted $C_7$ to $C_{11}$ arylalkylene group, which is advantageous for further improving the photocuring performance of the ink composition.

Specifically, an active diluent free radical monomer can be a monofunctional monomer, a bifunctional monomer, a multifunctional monomer, or a mixture. The "monofunctional" monomer refers to a monomer containing one photocurable functional group. Similarly, the "bifunctional" monomer refers to a monomer containing two photocurable functional groups, and the "multifunctional" monomer refers to a monomer containing three or more photocurable functional groups. In some preferred embodiments of the present application, a photocuring active diluent is a monomer containing two to four photocurable functional groups. The active diluent can also be a mixture of a monofunctional curable monomer, a bifunctional curable monomer, and a multifunctional curable monomer. By way of example, but not limitation of

the present application, in the ink composition, a monofunctional active diluent monomer and a bifunctional active diluent monomer or a multifunctional active diluent monomer can be mixed in the range of 1:0.1 to 1:10, which can better synergize with the photocurable silicon-containing monomer in the composition and achieve excellent photocuring effect.

For example, the above-mentioned monofunctional active diluent monomer can be a monofunctional (meth) acrylate of $C_1$ to $C_{30}$ monohydric or polyhydric alcohol; the bifunctional active diluent monomer can be a bifunctional (meth) acrylate of $C_2$ to $C_{30}$ monohydric or polyhydric alcohol; and the multifunctional active diluent monomer can be a multifunctional (meth)acrylate of $C_3$ to $C_{30}$ monohydric or polyhydric alcohol.

In some embodiments of the present application, the monofunctional active diluent includes alkyl acrylate, hydroxyl (meth)acrylate, (meth)acrylate with a cyclic structure or benzene ring, or a vinyl monomer, etc. Specific examples include: lauryl acrylate (LA), ethoxyethoxyethyl acrylate (EOEOEA), butyl acrylate (BA), hydroxyethyl acrylate, isobornyl acrylate, Ethoxylated tetrahydrofuran acrylate (THF(EO)A), phosphate methacrylate, 2-methyl-2-adamantyl acrylate, or isobornyl methacrylate.

In some embodiments of the present application, the bifunctional active diluent includes any one or more selected from the group consisting of ethylene glycol diacrylate, propylene glycol diacrylate, and other diol diacrylate. Specific structures can be listed as follows: diethylene glycol diacrylate (DEGDA), triethylene glycol diacrylate (TEGDA), ethylene diacrylate, polyethylene glycol (200) diacrylate [PEG(200)DA], polyethylene glycol (400) diacrylate [PEG(400) DA], polyethylene glycol (600) diacrylate [PEG(600)DA], neopentyl glycol diacrylate, propoxylate neopentylene glycol diacrylate, 1,6-hexanedioldiacrylate (HDDA), 1,4-butanediol diacrylate (BDDA), ethoxylated (20) bisphenol A diacrylate [$BPA(EO)_{20}DA$], tripropylene glycol diacrylate (TPGDA), and decanediol diacrylate.

In some embodiments of the present application, the multifunctional active diluent includes one or more selected from the group consisting of trimethylolpropane triacrylate (TMPTA), pentaerythritol triacrylate (PETA), trimethylolpropane trimethacrylate (TMPTMA), trimethylolpropane propoxylate triacrylate, pentaerythritol propoxylate tetraacrylate, ditrimethylolpropane tetraacrylate, triethylene glycol dimethacrylate, long-chain aliphatic hydrocarbon glycidyl ether acrylate, dipentaerythritol hexaacrylate, tripropylene glycol diacrylate, phthalic diglycol diacrylate (PDDA), ethoxylated trimethylolpropane triacrylate [TMP(EO)TMA], propoxylate trimethylolpropane triacrylate [TMP(PO)TMA], propylene glycerol triacrylate [G(PO)TA], 3-(2-hydroxyethyl)isocyanurate triacrylate, and ethoxylated neopentyl glycol methoxy monoacrylate [TMP(PO)MEDA].

The above-mentioned photoinitiator component can be selected from the prior art. In some embodiments of the present application, the photoinitiator component includes any one or more selected from the group consisting of a benzoin initiator and a derivative initiator thereof, a benzil initiator and a derivative initiator thereof, an acetophenone derivative initiator, an alpha-hydroxyketone derivative initiator, an alpha-aminoketone derivative initiator, a methyl benzoylformate initiator, an acyl phosphorus oxide initiator, a benzophenone initiator, a thioanthrone initiator, and an anthraquinone initiator and a derivative initiator thereof.

The content of each component in the ink composition, including the photocurable silicon-containing monomer component, the active diluent component, and the photoinitiator component, can be determined according to existing technology. In some embodiments of the present application, by weight percentage, the ink composition includes 0.01%-50% of the photocurable silicon-containing monomer component, 30%-80% of the active diluent component, and 0.01%-20% of the photoinitiator component. The ink composition with this content has better overall performance and is conducive to cost control. In some preferred embodiments, in the ink composition, by weight percentage, the content of the photocurable silicon-containing monomer component is 15%-50%, the content of the active diluent component is 40%-80%, and the content of the photoinitiator component is 1%-10%. The performance of the ink composition is better, especially the formed package structure has a lower dielectric constant, smaller dielectric loss, and more guaranteed package performance.

In a preferred embodiment, in addition to the above-mentioned components, the ink composition of the present application can also selectively add commonly used organic and/or inorganic adjuvants in the field, including (but not limited to) a polymerization inhibitor, a surfactant, an antioxidant, a defoamer, a leveling agent, etc., according to the needs of the product application environment. This is easy for technical personnel in the field to choose according to their own product requirements, and will not be further described here. As a preferred option, the content of the adjuvant component is 0.01 wt%-5 wt%, which can exert the performance of the adjuvant under better overall performance such as dielectric constant, photocuring efficiency, and light transmittance.

In order to further enhance the above-mentioned performance of the ink composition, in some preferred embodiments of the present application, the ink composition includes 5-10 parts by weight of a photocurable silicon-containing monomer component, 70-80 parts by weight of a bifunctional active diluent component, 5-10 parts by weight of a photoinitiator, and 1-5 parts by weight of an adjuvant; alternatively, the ink composition includes 10-20 parts by weight of a photocurable silicon-containing monomer component, 60-70 parts by weight of a bifunctional active diluent component, 5-10 parts by weight of a photoinitiator, and 1-5 parts by weight of an adjuvant; alternatively, the ink composition includes 20-30 parts by weight of a photocurable silicon-containing monomer component, 50-60 parts by weight of a bifunctional active diluent component, 5-10 parts by weight of a photoinitiator, and 1-5 parts by weight of an adjuvant; alternatively, the

ink composition includes 30-40 parts by weight of a photocurable silicon-containing monomer component, 40-50 parts by weight of a bifunctional active diluent component, 5-10 parts by weight of a photoinitiator, and 1-5 parts by weight of an adjuvant; alternatively, the ink composition includes 40-50 parts by weight of a photocurable silicon-containing monomer component, 30-40 parts by weight of a bifunctional active diluent component, 5-10 parts by weight of a photoinitiator, and 1-5 parts by weight of an adjuvant; and alternatively, the ink composition includes 30-40 parts by weight of a photocurable silicon-containing monomer component, 40-50 parts by weight of a bifunctional active diluent component, and 10-15 parts by weight of a photoinitiator.

The above-mentioned ink composition has a relatively suitable viscosity. For more convenient applications, such as a typical ink-jet printing method, a viscosity of the above-mentioned ink composition at 25°C is 1 mPa·s-50 mPa·s.

According to another typical embodiment of the present application, provided is a package structure including an organic layer, wherein the organic layer is formed by photocuring any one of the ink compositions described above.

The above-mentioned package structure, due to the use of the ink composition containing the above-mentioned photocurable silicon-containing monomer component, has a high photocuring rate and low curing shrinkage rate. The formed organic layer not only has high light transmittance and reliable performance, but also has a very low dielectric constant, which can reduce the dielectric loss of the package structure and has excellent overall performance.

According to yet another typical embodiment of the present application, provided is a semiconductor device including a functional structure and a package structure, wherein the package structure is the package structure described above.

The semiconductor device provided in the present application has a package structure formed by photocuring the above-mentioned ink composition, with high photocuring rate, low curing shrinkage rate, and low dielectric constant. Therefore, the package effect is more stable and reliable, better protecting the functional structure inside the semiconductor device from water vapor and oxygen erosion, improving the reliability and service life of OLED devices. At the same time, due to the low dielectric constant of the package structure, the dielectric consumption is reduced, further improving the safety of the semiconductor device.

As a preferred option, when the above-mentioned semiconductor device is any one of an electroluminescent device, a photoluminescent device, a lighting apparatus, a light-emitting diode, a solar cell, a thin film transistor, and a photodetector, the use of the above-mentioned package structure yields better results.

The following will further illustrate the beneficial effects that can be achieved by the present application through examples and comparative examples.

Preparation Example

Example 1 Preparation of Compound 1-1 (A1)

In a 2000 mL flask with a cooling tube and stirrer, 800 mL of toluene, 67 g of tetramethyldisiloxane, and 240 g of allyl alcohol were added, followed by nitrogen purging for 60 minutes. Afterwards, 0.0063 g of platinum(0)-1,3-divinyl-1,1,3,3-tetramethyldisiloxane was placed in the flask, and the temperature of the flask was increased to 70°C, followed by stirring for 5 hours. The residual solvent was removed by distillation, then 125 g of the obtained compound was introduced into a 1 L reaction vessel. After adding 200 mL of toluene and 200 mL of n-heptane, 112.5 g of 2-fluoroacrylic acid was added, 0.75 g of p-methoxyphenol and 1.8 g of cuprous chloride were added, and then 9.5 g of catalyst p-toluenesulfonic acid was added, heated up to 105°C for reflux reaction for 16 hours. The water generated by the reaction was fractionated through a water separator. The reaction process was monitored by detecting an acid value. After stopping the reaction, the residual solvent was removed by distillation, the mixture was washed with 500 mL of 1% NaOH aqueous solution, and washed three times with deionized water. The organic phase was collected and concentrated to obtain 147.5 g of a product with a yield of 75%. From this, a photocurable silicon-containing monomer compound represented by Formula 1 was prepared, denoted as A1, which had a purity of 98% as determined by HPLC. m/e: 394.14; elemental analysis: $C_{16}H_{28}O_5F_2Si_2$, a calculated value C: 48.71, Si: 14.24, F: 9.63, O: 20.27, H: 7.15, a measured value C: 48.77, Si: 14.26, F: 9.62, O: 20.21, H: 7.14.

[Formula 1]

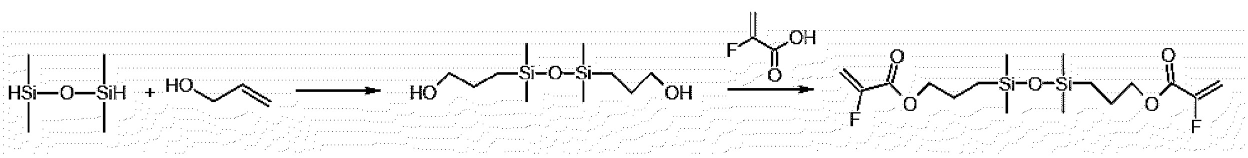

Example 2 Preparation of Compound 1-2 (A2)

In a 500 mL flask with a cooling tube and stirrer, 200 mL of dichloromethane, 69 g of triphenylsilanol, and 36 g of triethylamine were added. The flask was moved to a low-temperature reaction tank, cooled to 0°C, slowly added with 43 g of dimethyl-3-chloropropylchlorosilane dropwise, and the temperature was maintained at 0°C-5°C for 16 hours before stopping the reaction. The white solid was filtered out, the filtrate was collected, and concentrated to obtain an intermediate of a first step. 103 g of the obtained compound was transferred to a 1000 mL three-necked bottle, 5 g of cuprous chloride as a polymerization inhibitor, 1.2 g of p-methoxyphenol, and 500 mL of toluene as a solvent were added, then 33.6 g of sodium 2-fluoroacrylate was added, and heated up to 110°C for reflux reaction for 24 hours. The organic phase was filtered and collected, the toluene solvent was removed by distillation, and the residue was separated by column chromatography (mobile phase petroleum ether: ethyl acetate = 10:1) to obtain 83.5 g of a silicon-containing compound capped with 2-fluoroacrylate, with a yield of 72%. From this, the compound represented by Formula 2 was prepared, denoted as A2, which had a purity of 97% as determined by HPLC, m/e: 464.16; elemental analysis: $C_{26}H_{29}O_3FSi_2$, a calculated value C: 67.20, Si: 12.09, F: 4.09, O: 10.33, H: 6.29, a measured value C: 67.33, Si: 12.05, F: 4.04, O: 10.29, H: 6.29.

[Formula 2]

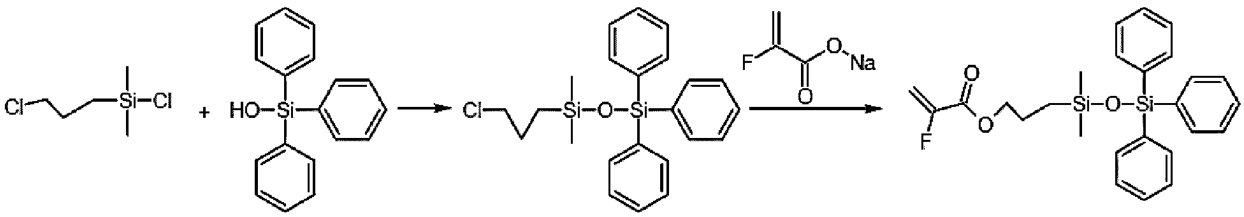

Example 3 Preparation of Compound 1-3 (A3)

In a 2000 mL flask with a cooling tube and stirrer, 800 mL of toluene, 67 g of tetramethyldisiloxane, and 240 g of allyl alcohol were added, followed by nitrogen purging for 60 minutes. Afterwards, 0.0063 g of platinum(0)-1,3-divinyl-1,1,3,3-tetramethyldisiloxane was placed in the flask, and the temperature of the flask was increased to 70°C, followed by stirring for 5 hours. The residual solvent was removed by distillation, then 125 g of the obtained compound was introduced into a 1 L reaction vessel. After adding 200 mL of toluene and 200 mL of n-heptane, 175 g of trifluoromethyl acrylic acid was added, 0.75 g of p-methoxyphenol and 1.8 g of cuprous chloride were added, and then 9.5 g of catalyst p-toluenesulfonic acid was added, heated up to 105°C for reflux reaction for 16 hours. The water generated by the reaction was fractionated through a water separator. The reaction process was monitored by detecting an acid value. After stopping the reaction, the residual solvent was removed by distillation, the mixture was washed with 500 mL of 1% NaOH aqueous solution, and washed three times with deionized water. The organic phase was collected and concentrated to obtain 178 g of a product with a yield of 72%. From this, a compound represented by Formula 3 was prepared, denoted as A3, which had a purity of 92% as determined by HPLC. m/e: 494.14; elemental analysis: $C_{18}H_{28}O_5F_6Si_2$, a calculated value C: 43.71, Si: 11.36, F: 23.05, O: 16.17, H: 5.71, a measured value C: 43.83, Si: 11.26, F: 23.04, O: 16.17, H: 5.70.

[Formula 3]

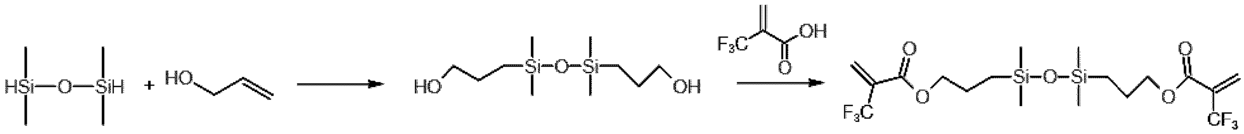

Example 4 Preparation of Compound 1-4 (A4)

In a 2000 mL flask with a cooling tube and stirrer, 800 mL of toluene, 104 g of 1,1,5,5-tetramethyl-3,3-diphenyltrisiloxane (Shanghai Shiyang Chemical), and 240 g of allyl alcohol were added, followed by nitrogen purging for 60 minutes. Afterwards, 0.0092 g of platinum(0)-1,3-divinyl-1,1,3,3-tetramethyldisiloxane was placed in the flask, and the temperature of the flask was increased to 70°C, followed by stirring for 5 hours. The residual solvent was removed by distillation, then 162 g of the obtained compound was introduced into a 1 L reaction vessel. After adding 200 mL of toluene and 200 mL of n-heptane, 112.5 g of 2-fluoroacrylic acid was added, 0.75 g of p-methoxyphenol and 1.8 g of cuprous

chloride were added, and then 9.5 g of catalyst p-toluenesulfonic acid was added, heated up to 105°C for reflux reaction for 16 hours. The water generated by the reaction was fractionated through a water separator. The reaction process was monitored by detecting an acid value. After stopping the reaction, the residual solvent was removed by distillation, the mixture was washed with 500 mL of 1% NaOH aqueous solution, and washed three times with deionized water. The organic phase was collected and concentrated to obtain 147.4 g of a product with a yield of 63%. From this, a compound represented by Formula 4 was prepared, denoted as A4, which had a purity of 98% as determined by HPLC. m/e: 468.16; elemental analysis: $C_{18}H_{34}O_6F_2Si_3$, a calculated value C: 46.13, Si: 17.98, F: 8.11, O: 20.48, H: 7.31, a measured value C: 48.77, Si: 18.05, F: 8.05, O: 20.46, H: 7.31.

[Formula 4]

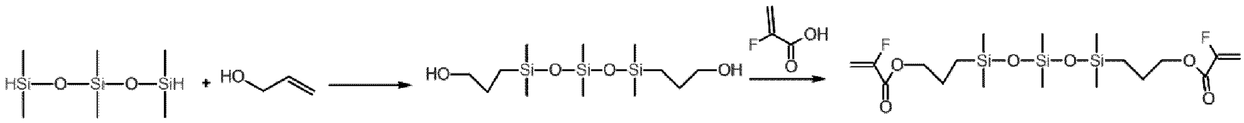

Example 5 Preparation of Compound 1-8 (A5)

In a 1000 mL flask with a cooling tube and stirrer, 800 mL of toluene, 54.11 g of 1,1,3,5,5-pentamethyl-3-phenyltrisiloxane, and 100 g of allyl alcohol were added, followed by nitrogen purging for 60 minutes. Afterwards, 0.0063 g of platinum(0)-1,3-divinyl-1,1,3,3-tetramethyldisiloxane was placed in the flask, and the temperature of the flask was increased to 70°C, followed by stirring for 5 hours. The residual solvent was removed by distillation, then 79 g of the obtained compound was introduced into a 1 L reaction vessel. After adding 200 mL of toluene and 200 mL of n-heptane, 45 g of 2-fluoroacrylic acid was added, 0.375 g of p-methoxyphenol and 0.9 g of cuprous chloride were added, and then 4.75 g of catalyst p-toluenesulfonic acid was added, heated up to 105°C for reflux reaction for 16 hours. The water generated by the reaction was fractionated through a water separator. The reaction process was monitored by detecting an acid value. After stopping the reaction, the residual solvent was removed by distillation, the mixture was washed with 250 mL of 1% NaOH aqueous solution, and washed three times with deionized water. The organic phase was collected and concentrated to obtain 78.5 g of a product with a yield of 74%. From this, a compound represented by formula 5 was prepared, denoted as A5, which had a purity of 97% as determined by HPLC. m/e: 530.18; elemental analysis: $C_{23}H_{36}O_6F_2Si_3$, a calculated value C: 52.05, Si: 15.87, F: 7.16, O: 18.09, H: 6.84, a measured value C: 51.89, Si: 15.93, F: 7.21, O: 18.13, H: 6.85.

[Formula 5]

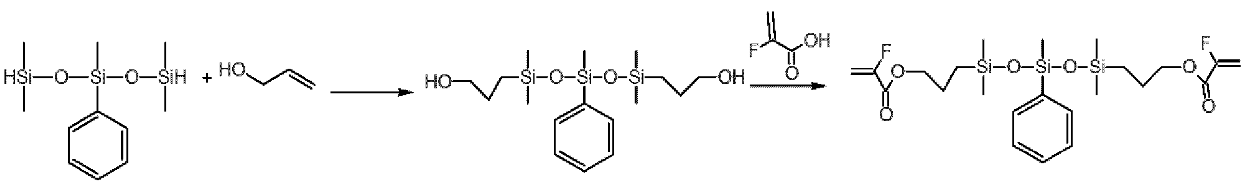

Example 6 Preparation of Compound 1-12 (A6)

In a 1000 mL flask with a cooling tube and stirrer, 200 mL of toluene, 91.7 g of 1,1,3-trimethyl-3-phenyldisiloxane, and 174 g of allyl alcohol were added, followed by nitrogen purging for 60 minutes. Afterwards, 0.0049 g of platinum(0)-1,3-divinyl-1,1,3,3-tetramethyldisiloxane was placed in the flask, and the temperature of the flask was increased to 70°C, followed by stirring for 5 hours. The residual solvent was removed by distillation, then 156 g of the obtained compound was introduced into another 1 L reaction vessel. After adding 200 mL of toluene and 200 mL of n-heptane, 175 g of trifluoromethyl acrylic acid was added, 0.75 g of p-methoxyphenol and 1.8 g of cuprous chloride were added, and then 9.5 g of catalyst p-toluenesulfonic acid was added, heated up to 105°C for reflux reaction for 16 hours. The water generated by the reaction was fractionated through a water separator. The reaction process was monitored by detecting an acid value. After stopping the reaction, the residual solvent was removed by distillation, the mixture was washed with 500 mL of 1% NaOH aqueous solution, and washed three times with deionized water. The organic phase was collected and concentrated to obtain 200 g of a product with a yield of 72%. From this, a compound represented by Formula 3 was prepared, denoted as A6, which had a purity of 96% as determined by HPLC. m/e: 556.15; elemental analysis: $C_{23}H_{30}O_5F_6Si_2$, a calculated value C: 49.63, Si: 10.09, F: 20.48, O: 14.37, H: 5.43, a measured value C: 49.47, Si:

10.22, F: 20.63, O: 14.46, H: 5.52.

[Formula 6]

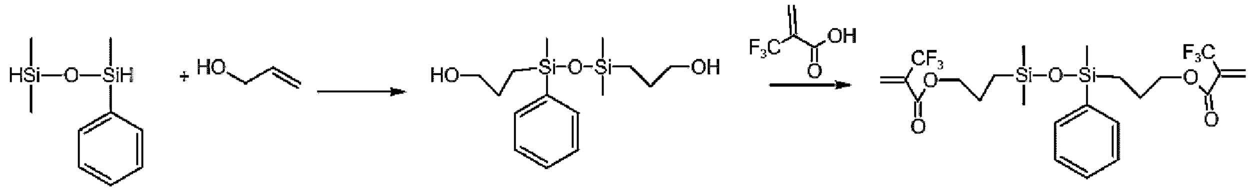

Test Example

The details of the components used in the test example and test comparative example are as follows, with specific contents shown in Tables 1 and 2:

(A) photocurable silicon-containing monomers A1-A6, the silicon containing monomers for each test example and test comparative example are shown in Table 1 and Table 2;

(B) active diluent component: decanediol diacrylate (Macklin);

(C) active diluent component: 2-methyl-2-adamantyl acrylate (Macklin);

(D) photoinitiator: TPO (Kaiyin Chemical);

(E) comparison compound of photocurable monomer;

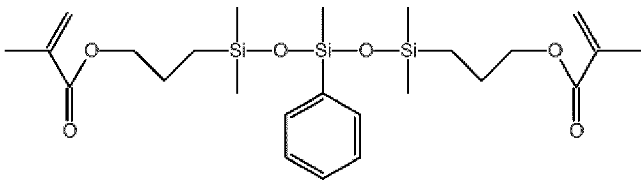

(E1)

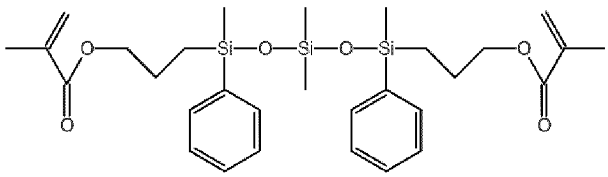

(E2)

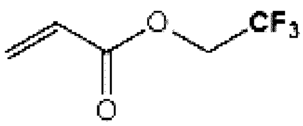

(E3)

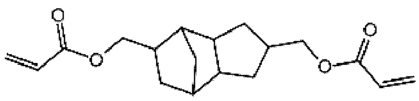

(E4)

(Z) leveling agent: BYK399.

Table 1

| Test raw materials | | Test examples | | | | | | | | | | |
|---|---|---|---|---|---|---|---|---|---|---|---|---|
| | | 1 | 2 | 3 | 4 | 5 | 6 | 7 | 8 | 9 | 10 | 11 |
| A-E | A1 | 30 | - | - | - | - | - | - | 20 | 20 | 20 | 15 |
| | A2 | - | 30 | - | - | - | - | 20 | - | - | - | - |
| | A3 | - | - | 30 | - | - | - | - | - | - | - | - |
| | A4 | - | - | - | 30 | - | - | - | 10 | 30 | 30 | - |
| | A5 | - | - | - | - | 30 | - | - | - | - | - | - |
| | A6 | - | - | - | - | - | 30 | 10 | - | - | - | - |
| | E1 | - | - | - | - | - | - | - | - | - | - | - |
| | E2 | - | - | - | - | - | - | - | - | - | - | - |
| | E3 | - | - | - | - | - | - | - | - | - | - | - |
| B | | 40 | 40 | 40 | 40 | 40 | 40 | 40 | 40 | 30 | 40 | 40 |
| C | | 25 | 25 | 25 | 25 | 25 | 25 | 25 | 25 | - | - | 40 |
| D | | 5 | 5 | 5 | 5 | 5 | 5 | 5 | 5 | 20 | 10 | 5 |
| Z | | 0.1 | 0.1 | 0.1 | 0.1 | 0.1 | 0.1 | 0.1 | 0.1 | 0.1 | 0.1 | 0.1 |

Table 2

| Test raw materials | | Test examples | | | Test comparative examples | | | | | | |
|---|---|---|---|---|---|---|---|---|---|---|---|
| | | 12 | 13 | 14 | 1 | 2 | 3 | 4 | 5 | 6 | 7 |
| | A1 | 5 | 30 | 20 | - | - | - | - | - | | |
| | A2 | - | - | - | - | - | - | - | - | | |
| | A3 | - | - | - | - | - | - | - | - | | |
| | A4 | - | 30 | 20 | - | - | - | - | - | | |
| | A5 | - | - | - | - | - | - | - | - | | |
| | A6 | - | - | - | - | - | - | - | - | | |
| | E1 | - | - | - | 30 | - | 15 | - | 15 | | |
| | E2 | - | - | - | - | 30 | 15 | - | - | | |
| | E3 | - | - | - | - | - | - | 30 | 15 | | |
| | E4 | | | | | | | | | 30 | 30 |
| B | | 40 | 35 | 30 | 40 | 40 | 40 | 40 | 40 | 40 | 40 |
| C | | 40 | - | 25 | 25 | 25 | 25 | 25 | 25 | 25 | 25 |
| D | | 15 | 5 | 4 | 5 | 5 | 5 | 5 | 5 | 5 | 5 |
| Z | | 0.1 | 0.1 | 1 | 0.1 | 0.1 | 0.1 | 0.1 | 0.1 | 0.1 | 0.1 |

The above-mentioned materials were mixed uniformly according to the proportions in Table 1 and Table 2, and then UV cured for the following tests:

<curing shrinkage rate (%)>

a composition was placed in a polytetrafluoroethylene mold and irradiated with 395 nm UV at 100 mW/$cm^2$ for 10 seconds for UV curing, then placed in a 60°C oven for 1 hour to fully cure the composition. After curing, a length of a sample was measured using a caliper. A curing shrinkage rate of a package composition was calculated according to the following equation:

$$\text{curing shrinkage rate (\%)} = (|C-D|/C) \times 100\%.$$

C was a length of the mold before curing, and D was a length of a sample after UV curing.

<Photocuring rate (%)>

An intensity of absorption peaks near 1635 $cm^{-1}$ (C=C) and 1720 $cm^{-1}$ (C=O) was measured using FT-IR on a composition used for package. A spray was used to apply the composition to a glass substrate, and then UV cured by irradiating it with 395 nm UV of 1000 $mW/cm^2$ for 10 seconds, and then placed in the 60°C oven for 1 hour to fully cure a sample, so as to obtain a sample with a size of 20 cm × 20 cm × 3 μm (width × length × thickness). Subsequently, FT-IR was used to measure an intensity of absorption peaks of a cured film near 1635 $cm^{-1}$ (C=C) and 1720 $cm^{-1}$ (C=O). A photocuring rate was calculated using the following equation:

$$\text{photocuring rate (\%)} = |1 - (A/B)| \times 100\%$$

wherein A was the ratio of the intensity of the absorption peak near 1635 $cm^{-1}$ to the intensity of the absorption peak near 1720 $cm^{-1}$ measured for the cured film, and B was the ratio of the intensity of the absorption peak near 1635 $cm^{-1}$ to the intensity of the absorption peak near 1720 $cm^{-1}$ measured for the composition used for package.

<Dielectric properties>

The photocurable composition was printed onto a substrate in an ink-jet manner, then irradiated with 395 nm UV light at 50-300 $mW/cm^2$ for 60 seconds and placed in a 80°C oven for 30 minutes to produce a thin film with a uniform thickness of about 10 μm. According to a parallel plate method (referring to the international standard ASTM D150), a capacitor was formed by inserting a thin film sample between two electrodes (silver), then its capacitance was measured, and a dielectric constant was calculated based on the measurement results. In an actual test apparatus, two electrodes were equipped on a test fixture that held dielectric materials. An impedance analyzer (4990A LCR, Agilent) would measure a capacitance and a dissipative vector component, and then a software program would calculate a dielectric constant and a loss tangent according to the following formula:

$$\varepsilon_r = \frac{t_m \times C_p}{A \times \varepsilon_0} = \frac{t_m \times C_p}{\pi (d/2)^2 \times \varepsilon_0}$$

$$\tan\delta = D$$

wherein $C_p$ is an equivalent parallel capacitance (F) of a test film, D is a loss tangent, $t_m$ is an average thickness of a test film sample (m), A is a surface area of the electrode ($m^2$), d is a diameter of the electrode (m), and $\varepsilon_0$ is a dielectric constant of free space = 8.854 × $10^{-12}$ (F/m).

<Light transmittance>

The photocurable composition was printed onto a substrate in an ink-jet manner, then irradiated with 395 nm UV light at 50-300 $mW/cm^2$ for 60 seconds and placed in a 80°C oven for 30 minutes to produce a 10 cm × 10 cm × 5 μm (width × length × thickness) film. A UV visible spectrophotometer testing system (Carry 5000, manufactured by Agilent Technologies, USA) was used to test a light transmittance of the organic package film in a visible light range of 380-780 nm.

<Ink-jet analysis>

A piezoelectric drop-on-demand print head (DMC11610) and a Japanese ink-jet device DMP2850 mini ink-jet printer were used for ink-jet printing testing. An ink-jet head was based on a piezoelectric material (PZT) and could be moved by applying an electric field. An ink channel composed of piezoelectric walls could spray small ink droplets based on an electrical signal applied to electrodes on the wall. A JetXPert ink observation instrument was used to capture images of the droplets at fixed time intervals of 10 microseconds (μsec).

<Viscosity>

A viscosity of the sample was measured using a flat rheometer at a temperature of 25°C and a shear rate of 10 r/s.

<Hardness>

Tested according to GB/T 6739-2006.

The above-mentioned test items and test results were listed in Tables 3 and 4.

Table 3

| Test items | Test examples | | | | | | | | | | |
|---|---|---|---|---|---|---|---|---|---|---|---|
| | 1 | 2 | 3 | 4 | 5 | 6 | 7 | 8 | 9 | 10 | 11 |
| Viscosity (cp) | 22 | 22 | 17 | 25 | 24 | 24 | 19 | 19 | 21 | 22 | 20 |
| Curing shrinkage rate (%) | 4.9 | 5.1 | 5.2 | 4.9 | 5.5 | 5.7 | 5.4 | 5.5 | 5.0 | 5.2 | 4.9 |
| Photocuri ng rate (%) | 95.3 | 96.8 | 95.4 | 94.1 | 95.6 | 95.5 | 94.9 | 95.8 | 95.4 | 95.5 | 94.9 |
| Light transmitta nce | 95.8 | 96.4 | 96.4 | 95.9 | 96.8 | 96.9 | 97.2 | 96.7 | 96.4 | 97.4 | 96.5 |
| Dielectric constant (F/m) | 2.7 | 2.8 | 2.8 | 2.9 | 2.7 | 2.7 | 2.8 | 2.8 | 2.7 | 2.8 | 2.9 |
| Hardness | 2H | 2H | 2H | 3H | 3H | 2H | 3H | 2H | 2H | 2H | 3H |
| Ink-jet smoothne ss | Smo oth | Smo oth | Smo oth | Smo oth | Smo oth | Smo oth | Smo oth | Smo oth | Smo oth | Smo oth | Smo oth |

Table 4

| Test items | Test examples | | | Test comparative examples | | | | | | |
|---|---|---|---|---|---|---|---|---|---|---|
| | 12 | 13 | 14 | 1 | 2 | 3 | 4 | 5 | 6 | 7 |
| Viscosity | 26 | 25 | 29 | 26 | 31 | 27 | 24 | 21 | 36 | 32 |
| Curing shrinkage rate (%) | 5.5 | 5.6 | 5.3 | 5.6 | 5.8 | 5.6 | 6.7 | 7.2 | 6.3 | 5.7 |
| Photocurin g rate (%) | 94.9 | 93.9 | 94.7 | 94.5 | 93.2 | 94.2 | 94.1 | 94.5 | 94.5 | 95.2 |
| Light transmittan ce | 95.6 | 95.9 | 95.2 | 95.5 | 95.7 | 96.2 | 93.7 | 94.1 | 93.8 | 94.1 |
| Dielectric constant (F/m) | 3.0 | 2.9 | 2.7 | 3.4 | 3.5 | 3.5 | 3.0 | 3.0 | 3.1 | 3.0 |
| Hardness | 2H | 3H | 3H | 2H | 3H | 2H | 2H | 2H | 2H | 2H |
| Ink-jet smoothnes s | Smoo th | Smoo th | Smoo th | Smoo th | Smoo th | Smoo th | Blocki ng holes | Blocki ng holes | Smoo th | Smoo th |

The organic package ink composition made from the photocurable composition including fluorine-substituted silicon-containing monomers introduced in Examples A to E exhibited excellent properties in terms of water vapor transmission rate, curing volume shrinkage rate, light transmittance, glass transition temperature, heat resistance, and dielectric constant, especially the dielectric constant surpassing that of the ink composition without fluorine (Test Comparative Examples 1-3); and due to the addition of the low boiling point monomers, although the dielectric constant of Comparative Examples 4 and 5 was relatively low, they were prone to evaporation and pore blockage during the ink-jet process.

From the above-mentioned description, it can be seen that the above-mentioned embodiments of the present disclosure have achieved the following technical effects: the photocurable monomer component used in the present application is a fluorine-substituted photocurable silicon-containing monomer, and the fluorine-substituted silicon-containing monomer is combined with the active diluent component to form a free radical curing system, which can effectively reduce the dielectric constant and improve the curing speed. Due to the high boiling point of the fluorine-substituted silicon-containing monomer in the ink composition of the present application, it is not easy to evaporate, avoiding blockage of ink holes during use and better meeting the requirements of ink-jet printing in the prior art. In addition, the fluorine-substituted silicon-containing monomer of the present application is simple to prepare, and the raw materials are cheap and easy to obtain, which can well meet the package requirements of existing electronic devices such as OLED devices.

The embodiments described above are just preferred embodiments of the present disclosure and are not used for limiting the present disclosure. For those skilled in the art, the present disclosure may have various modifications and variations. Any modification, equivalent replacement, improvement and the like made within the spirit and principle of the present disclosure shall be still included in the protection scope of the present disclosure.

## Claims

1. An ink composition, comprising: a photocurable silicon-containing monomer component, an active diluent component, and a photoinitiator component, wherein the photocurable silicon-containing monomer component comprises any one or more compounds having the following structural formula I:

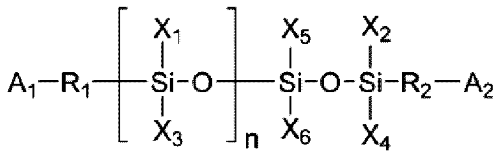

structural formula I

where n is any integer from 0 to 50; $R_1$ and $R_2$ are the same or different, and are each independently selected from any one of a single bond, a substituted or unsubstituted $C_1$ to $C_{50}$ alkylene group, a substituted or unsubstituted $C_3$ to $C_{50}$ cycloalkylene group, a substituted or unsubstituted $C_1$ to $C_{50}$ alkylene ether group, a substituted or unsubstituted $C_6$ to $C_{50}$ arylene group, or a substituted or unsubstituted $C_7$ to $C_{50}$ arylalkylene group; $X_1$, $X_2$, $X_3$, $X_4$, $X_5$, and $X_6$ are the same or different, and are each independently selected from any one of a hydrogen, a substituted or unsubstituted $C_1$ to $C_{50}$ alkyl group, a substituted or unsubstituted $C_1$ to $C_{50}$ alkyl ether group, a substituted or unsubstituted $C_1$ to $C_{50}$ cycloalkyl group, a substituted or unsubstituted $C_1$ to $C_{50}$ alkyl sulfide group, a substituted or unsubstituted $C_6$ to $C_{50}$ aryl group, a substituted or unsubstituted $C_3$ to $C_{50}$ heteroaryl group, a substituted or unsubstituted $C_7$ to $C_{50}$ aralkyl group, or $-NR_6R_7$, wherein $R_6$ and $R_7$ each independently is a $C_1$ to $C_{50}$ alkyl group; $A_1$ and $A_2$ are the same or different, and are independently selected from any one of a hydrogen, a substituted or unsubstituted $C_1$ to $C_{50}$ alkyl group, a substituted or unsubstituted $C_1$ to $C_{60}$ alkyl ether group, a substituted or unsubstituted $C_1$ to $C_{50}$ alkyl sulfide group, a substituted or unsubstituted $C_6$ to $C_{50}$ aryl group, a substituted or unsubstituted $C_7$ to $C_{50}$ aralkyl group, $-NR_8R_9$, a substituted or unsubstituted acrylic ester group, a substituted or unsubstituted $C_3$ to $C_{60}$ epoxyalkyl group, a substituted or unsubstituted $C_2$ to $C_{60}$ epoxy group, or a substituted or unsubstituted $C_2$ to $C_{60}$ alkenyl ether group, wherein $R_8$ and $R_9$ each independently is a $C_1$ to $C_{50}$ alkyl group; and in the photocurable silicon-containing monomer component, at least one of $A_1$ and $A_2$ is represented by any one of structural formula II:

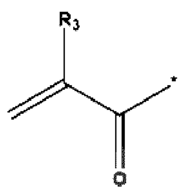

structural formula II

wherein * represents a binding position, and $R_3$ is independently selected from one of -F or $-CF_3$.

2. The ink composition according to claim 1, wherein n is any integer from 1 to 10.

3. The ink composition according to claim 2, wherein the $R_1$ and $R_2$ are each independently selected from any one of a substituted or unsubstituted $C_1$ to $C_{10}$ alkylene group, or a substituted or unsubstituted $C_1$ to $C_{10}$ alkylene ether group.

4. The ink composition according to claim 2, wherein $X_1$, $X_2$, $X_3$, $X_4$, $X_5$, and $X_6$ are each independently selected from any one of a hydrogen, a substituted or unsubstituted $C_1$ to $C_{10}$ alkyl group, a substituted or unsubstituted $C_6$ to $C_{10}$ aryl group, or a substituted or unsubstituted $C_7$ to $C_{11}$ aralkyl group.

5. The ink composition according to claim 2, wherein the photocurable silicon-containing monomer component is a combination of multiple compounds having structural formula I.

6. The ink composition according to claim 2, wherein the photocurable silicon-containing monomer component is selected from the following compound structures:

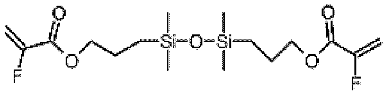
1-1 ,

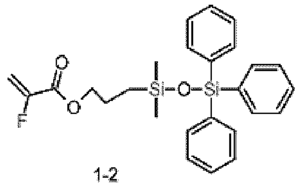
1-2 ,

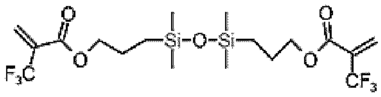
1-3 ,

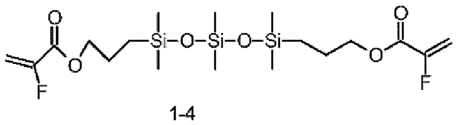
1-4 ,

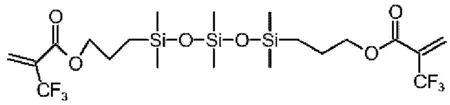
1-5 ,

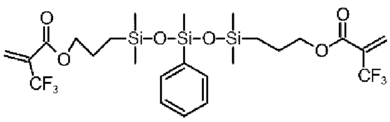
1-6 ,

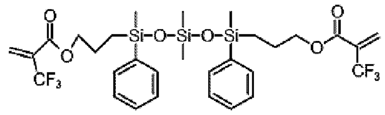
1-7 ,

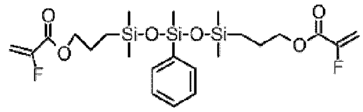
1-8 ,

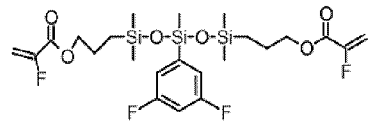
1-9 ,

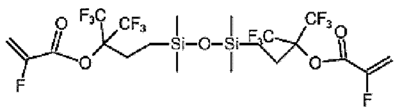
1-10 ,

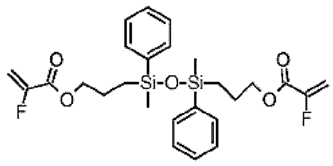
1-11 ,

or

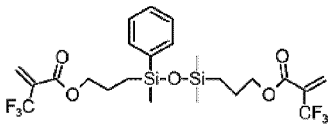
1-12 .

7. The ink composition according to claim 1, wherein the active diluent component comprises any one or more of the structures shown in structural formula V,

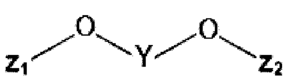
structural formula V

where Y is selected from any one of a single bond, a substituted or unsubstituted $C_1$ to $C_{50}$ alkylene group, a substituted or unsubstituted $C_3$ to $C_{50}$ cycloalkylene group, a substituted or unsubstituted $C_1$ to $C_{50}$ alkylene ether group, a substituted or unsubstituted $C_6$ to $C_{50}$ arylene group, a substituted or unsubstituted $C_7$ to $C_{50}$ arylalkylene

group, or -N($R_{11}$)-$R_{12}$-; wherein $R_{11}$ is any one of a hydrogen, or a substituted or unsubstituted $C_1$ to $C_{50}$ alkyl group, and $R_{12}$ is any one of a substituted or unsubstituted $C_1$ to $C_{50}$ alkylene group; $Z_1$ and $Z_2$ are each independently selected from any one of a hydrogen, a substituted or unsubstituted $C_1$ to $C_{50}$ alkyl group, a substituted or unsubstituted $C_1$ to $C_{60}$ alkyl ether group, a substituted or unsubstituted acrylic ester group, or a substituted or unsubstituted $C_2$ to $C_{60}$ alkenyl ether group, and at least one of $Z_1$ and $Z_2$ is represented by any one of structural formula VI,

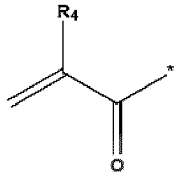

structural formula VI

wherein $R_4$ is selected from any one of a hydrogen, or a substituted or unsubstituted $C_1$ to $C_{50}$ alkyl group.

**8.** The ink composition according to claim 7, wherein the Y is selected from any one of a substituted or unsubstituted $C_1$ to $C_{10}$ alkylene group, a substituted or unsubstituted $C_1$ to $C_{10}$ alkylene ether group, a substituted or unsubstituted $C_6$ to $C_{10}$ arylene group, or a substituted or unsubstituted $C_7$ to $C_{11}$ arylalkylene group.

**9.** The ink composition according to claim 1, wherein the active diluent component comprises any one or more selected from the group consisting of a monofunctional active diluent, a bifunctional active diluent, and a multifunctional active diluent.

**10.** The ink composition according to claim 9, wherein the monofunctional active diluent comprises any one or more selected from the group consisting of lauryl acrylate, ethoxyethoxyethyl acrylate, butyl acrylate, hydroxyethyl acrylate and isobornyl acrylate, tetralydrofufuryl ethoxyacrylate, phosphate methacrylate, 2-methyl-2-adamantyl acrylate, and isobornyl methacrylate.

**11.** The ink composition according to claim 9, wherein the bifunctional active diluent comprises any one or more selected from the group consisting of ethylene diacrylate, propylene glycol diacrylate, and other glycol diacrylate.

**12.** The ink composition according to claim 9, wherein the multifunctional active diluent comprises one or more selected from the group consisting of trimethylolpropane triacrylate, pentaerythritol triacrylate, trimethylolpropane trimethacrylate, trimethylolpropane propoxylate triacrylate, pentaerythritol propoxylate tetraacrylate, ditrimethylolpropane tetraacrylate, triethylene glycol dimethacrylate, long-chain aliphatic hydrocarbon glycidyl ether acrylate, dipentaerythritol hexaacrylate, tripropylene glycol diacrylate, phthalic diglycol diacrylate, ethoxylated trimethylolpropane triacrylate, propoxylate trimethylolpropane triacrylate, propylene glycerol triacrylate, 3-(2-hydroxyethyl)isocyanurate triacrylate, and ethoxylated neopentyl glycol methoxy monoacrylate.

**13.** The ink composition according to claim 1, wherein the photoinitiator component comprises any one or more selected from the group consisting of a benzoin initiator and a derivative initiator thereof, a benzil initiator and a derivative initiator thereof, an acetophenone derivative initiator, an alpha-hydroxyketone derivative initiator, an alpha-aminoketone derivative initiator, a methyl benzoylformate initiator, an acyl phosphorus oxide initiator, a benzophenone initiator, a thioanthrone initiator, and an anthraquinone initiator and a derivative initiator thereof.

**14.** The ink composition according to any one of claims 1 to 13, wherein by weight percentage, the ink composition comprises: 0.01%-50% of the photocurable silicon-containing monomer component, 30%-80% of the active diluent component, and 0.01%-20% of the photoinitiator component.

**15.** The ink composition according to claim 14, wherein by weight percentage, the content of the photocurable silicon-containing monomer component is 15%-50%, the content of the active diluent component is 40%-80%, and the content of the photoinitiator component is 1%-10%.

**16.** The ink composition according to any one of claims 1 to 13, wherein the ink composition further comprises an adjuvant component.

**17.** The ink composition according to claim 16, wherein the adjuvant component is selected from any one or more of a polymerization inhibitor, a surfactant, an antioxidant, a defoamer, and a leveling agent.

**18.** The ink composition according to claim 16, wherein the content of the adjuvant component is 0.01 wt%-5 wt%.

**19.** The ink composition according to any one of claims 1 to 13, wherein a viscosity of the ink composition at 25°C is 1 mPa·s-50 mPa·s.

**20.** A package structure comprising an organic layer, wherein the organic layer is formed by photocuring the ink composition according to any one of claims 1 to 19.

**21.** A semiconductor device comprising a functional structure and a package structure, wherein the package structure is the package structure according to claim 20.

**22.** The semiconductor device according to claim 21, wherein the semiconductor device is any one of an electroluminescent device, a photoluminescent device, a light-emitting diode, a solar cell, a thin film transistor, and a photodetector.

**23.** The semiconductor device according to claim 21, wherein the semiconductor device is a lighting apparatus.

## INTERNATIONAL SEARCH REPORT

International application No. **PCT/CN2023/094582**

**A. CLASSIFICATION OF SUBJECT MATTER**

C09D11/101(2014.01)i；C09D11/30(2014.01)i；C09D11/36(2014.01)i；C09D183/04(2006.01)i；H01L33/56(2010.01)i；C08L83/04(2006.01)i；H01B3/46(2006.01)i

According to International Patent Classification (IPC) or to both national classification and IPC

**B. FIELDS SEARCHED**

Minimum documentation searched (classification system followed by classification symbols)

IPC:C09D H01L C08L H01B

Documentation searched other than minimum documentation to the extent that such documents are included in the fields searched

Electronic data base consulted during the international search (name of data base and, where practicable, search terms used)

CNABS; CNTXT; DWPI; CNKI: 硅, 树脂, 单体, 聚硅氧烷, 氟, 卤, 取代, 丙烯酸酯, 丙烯酰, 光, 紫外, 辐射, 固化, 活性稀释剂, 介电常数, silicon, resin, monomer, fluorine, halogen, photo, ultraviolet, UV, acrylate, acryl, active, diluent, dielectric, constant

**C. DOCUMENTS CONSIDERED TO BE RELEVANT**

| Category* | Citation of document, with indication, where appropriate, of the relevant passages | Relevant to claim No. |
|---|---|---|
| PX | CN 115109464 A (HANGZHOU FIRST APPLIED MATERIAL CO., LTD.) 27 September 2022 (2022-09-27) claims 1-12 | 1-23 |
| Y | CN 111826024 A (HANGZHOU FIRST APPLIED MATERIAL CO., LTD.) 27 October 2020 (2020-10-27) description, paragraphs 12-63 | 1-23 |
| Y | CN 113166540 A (DOW SILICONES CORP. et al.) 23 July 2021 (2021-07-23) description, paragraphs 14-129 | 1-23 |
| Y | CN 110982346 A (HANGZHOU FIRST APPLIED MATERIAL CO., LTD.) 10 April 2020 (2020-04-10) description, paragraphs 12-63 | 1-23 |
| Y | CN 114616299 A (DOW SILICONES CORP. et al.) 10 June 2022 (2022-06-10) description, paragraphs 16-189 | 1-23 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **14 June 2023** | **17 June 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**

International application No.
**PCT/CN2023/094582**

**C. DOCUMENTS CONSIDERED TO BE RELEVANT**

| Category* | Citation of document, with indication, where appropriate, of the relevant passages | Relevant to claim No. |
|---|---|---|
| A | CN 113135951 A (JILIN OLED MATERIAL TECH CO., LTD.) 20 July 2021 (2021-07-20) entire document | 1-23 |
| A | TW 201834161 A (SILICONWARE PRECISION INDUSTRIES CO., LTD.) 16 September 2018 (2018-09-16) entire document | 1-23 |
| A | JP 2005097443 A (JSR CORP.) 14 April 2005 (2005-04-14) entire document | 1-23 |

Form PCT/ISA/210 (second sheet) (July 2022)

**INTERNATIONAL SEARCH REPORT**
**Information on patent family members**

International application No.
**PCT/CN2023/094582**

| Patent document cited in search report | | | Publication date (day/month/year) | Patent family member(s) | | | Publication date (day/month/year) |
|---|---|---|---|---|---|---|---|
| CN | 115109464 | A | 27 September 2022 | None | | | |
| CN | 111826024 | A | 27 October 2020 | None | | | |
| CN | 113166540 | A | 23 July 2021 | JPWO | 2020090346 | A1 | 24 September 2021 |
| | | | | WO | 2020090346 | A1 | 07 May 2020 |
| | | | | KR | 20210084531 | A | 07 July 2021 |
| CN | 110982346 | A | 10 April 2020 | None | | | |
| CN | 114616299 | A | 10 June 2022 | US | 2022348722 | A1 | 03 November 2022 |
| | | | | WO | 2021066084 | A1 | 08 April 2021 |
| | | | | KR | 20220078629 | A | 10 June 2022 |
| | | | | JPWO | 2021066084 | A1 | 08 April 2021 |
| CN | 113135951 | A | 20 July 2021 | None | | | |
| TW | 201834161 | A | 16 September 2018 | TWI | 637468 | B | 01 October 2018 |
| JP | 2005097443 | A | 14 April 2005 | None | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 201880082492X
- TW 202130677 A
- US 20220002569 A
- CN 20200109954X
- CN 113004808 A